(19) Europäisches Patentamt
European Patent Office
Office européen des brevets

(11) **EP 3 007 218 B1**

(12) **FASCICULE DE BREVET EUROPEEN**

(45) Date de publication et mention
de la délivrance du brevet:
**21.06.2017   Bulletin 2017/25**

(51) Int Cl.:
**H01L 21/768** *(2006.01)*     **B82B 3/00** *(2006.01)*
**H01L 23/48** *(2006.01)*

(21) Numéro de dépôt: **15187234.8**

(22) Date de dépôt: **28.09.2015**

(54) **STRUCTURE D'ENCAPSULATION D'UN NANO-OBJET POURVUE D'UN CAPOT ET D'UN SUBSTRAT AVEC REPRISE DE CONTACT AU TRAVERS DU CAPOT, ET SON PROCEDE DE FABRICATION**

EINKAPSELUNGSSTRUKTUR FÜR EIN NANO-OBJEKT MIT EINEM DECKEL UND EINEM SUBSTRAT, WOBEI EIN KONTAKT DURCH DEN DECKEL ERSTELLT IST, SOWIE DESSEN HERSTELLUNGSVERFAHREN

ENCAPSULATION STRUCTURE OF A NANO-OBJECT PROVIDED WITH A LID AND A SUBSTRATE WITH CONTACT FEED-THROUGH IN THE LID, AND ITS MANUFACTURING METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.09.2014   FR 1459243**

(43) Date de publication de la demande:
**13.04.2016   Bulletin 2016/15**

(73) Titulaire: **Commissariat à l'Énergie Atomique et aux Énergies Alternatives**
**75015 Paris (FR)**

(72) Inventeur: **BAILLIN, Xavier**
**38920 CROLLES (FR)**

(74) Mandataire: **Brevalex**
**95, rue d'Amsterdam**
**75378 Paris Cedex 8 (FR)**

(56) Documents cités:
**FR-A1- 2 992 773**

**EP 3 007 218 B1**

**Description**

**DOMAINE TECHNIQUE**

La présente invention concerne une structure d'encapsulation pourvue d'un capot et d'un substrat, pour connecter électriquement au moins un nano-objet sur une face du substrat et en reprendre le contact électrique au travers du capot. Elle concerne aussi un procédé de fabrication de la structure.

Elle permet de réaliser collectivement des structures comportant au moins un nano-objet encapsulé de façon hermétique sous atmosphère contrôlée ; et elle s'applique notamment à la fabrication de systèmes microélectroniques de type « Beyond CMOS », utilisant les propriétés spécifiques des nano-objets.

Les nano-objets (incluant les molécules, les nanotubes de carbone, les brins d'ADN, les protéines et, de façon générale, tout objet dont la taille est submicronique) nécessitent, pour déterminer au moins leur fonctionnalité (électrique, optique, sensitive...), d'être posés ou greffés ou encore hybridés sur un support équipé de connecteurs électriques dont l'état de surface doit être compatible avec l'accueil de nano-objet(s) et, avantageusement, dont la rugosité doit être maîtrisée et, avantageusement, de l'ordre de l'échelle atomique. Compte tenu de leur taille, la distance entre les connecteurs électriques doit être aussi proche que possible de la taille du nano-objet auquel on veut les relier.

De plus, afin de caractériser ou de faire fonctionner des nano-objets à l'air ambiant, il convient de les protéger de l'extérieur par un capot rendu hermétiquement solidaire du substrat. La structure d'encapsulation ainsi obtenue permet de réaliser l'équivalent d'un composant électronique, qu'il est ensuite possible de manipuler et de tester. En vue d'une intégration collective, il s'avère que l'emploi d'un substrat et d'un capot de type tranche (en anglais, *wafer*) reste une solution privilégiée compte tenu des technologies collectives, développées dans le cadre de l'industrie de la microélectronique, notamment la technique WLP, ou technique d'encapsulation sur tranche (en anglais, *waferlevel packaging technique).*

**ÉTAT DE LA TECHNIQUE ANTÉRIEURE**

Aujourd'hui il n'existe pas de solution technologique simple pour hybrider collectivement des nano-objets sur une tranche de silicium dont la surface a une rugosité parfaitement maîtrisée. On trouve des approches telles que celle décrite dans le document suivant :

**[1] WO 2009/022982, Nano-interconnects for atomic and molecular scale circuits.**

Dans ce document, la réalisation de connecteurs électriques traversants, appelés aussi vias traversants ou TSV (pour Trough Silicon Via), nécessite l'emploi d'un outil spécifique, à savoir un FIB, ou faisceau d'ions focalisé, (en anglais, *focused ion beam*) pour l'usinage localisé de ces vias dont le diamètre mais aussi la profondeur vont être limités par la méthode utilisée pour leur fabrication. Cette technologie ne peut pas utiliser un procédé collectif de photolithographie et gravure. De plus, le fait de devoir incliner les vias traversants afin de réduire leur espacement ajoute une complexité à l'usinage puisqu'il faut contrôler précisément l'angle d'inclinaison du faisceau d'ions par rapport au plan du substrat.

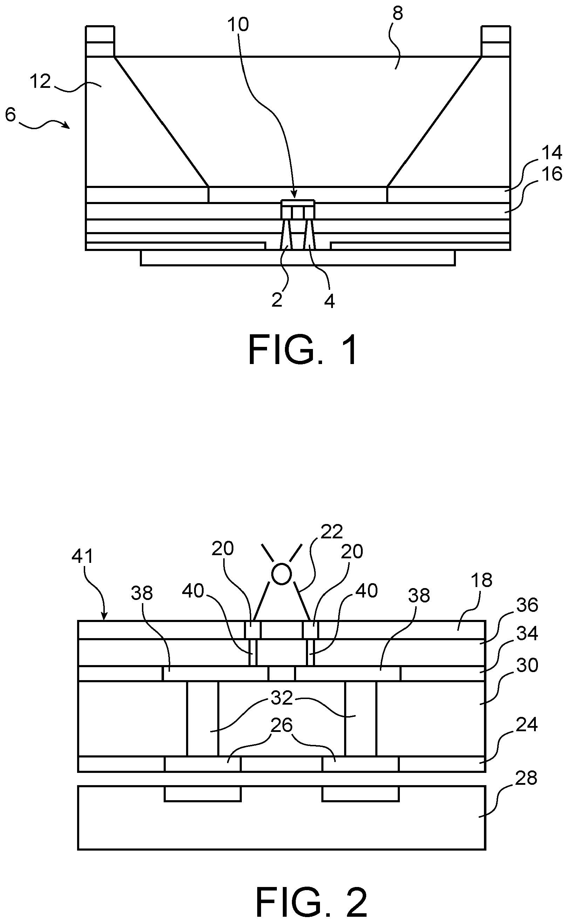

Cette technique connue est illustrée par la figure 1 qui est une vue en coupe schématique d'un support équipé d'interconnexions de taille nanométrique. Des nanovias 2, 4 sont usinés depuis la face inférieure d'un substrat 6. Ils débouchent sur la face intérieure, située au fond d'une cavité 8, là où sera placé un nano-objet 10 à connecter. Le substrat de départ est de type SOI ; il est composé d'une couche de silicium épaisse 12, puis d'une couche d'oxyde enterré (en anglais, *burried oxide*) 14, plus simplement appelée BOX, et enfin d'une fine couche de silicium 16, dans laquelle sont creusés les vias.

Une seconde approche est proposée dans le document suivant :

**[2] US 8 692 385, correspondant à FR 2 969 592 et à EP 2 469 589.**

Elle concerne un dispositif pour connecter des nano-objets à des systèmes électriques externes et s'applique notamment à la caractérisation de molécule(s). Selon cette seconde approche, on fabrique un dispositif comprenant : une couche supérieure pourvue de plots de contact supérieurs à connecter à un nano-objet ; une couche inférieure pourvue de plots de contact inférieurs à connecter à un système électrique externe ; une couche de liaison comprenant des vias électriques traversants en contact avec les plots inférieurs ; et, entre la couche de liaison et la couche supérieure, au moins deux couches pourvues de lignes conductrices et de vias électriques pour relier les plots supérieurs aux plots inférieurs.

La réalisation d'une telle structure nécessite de nombreuses opérations technologiques et notamment requiert une opération de dégagement de la face avant du substrat utilisé par une opération d'amincissement et polissage. Cette étape est critique car l'état de surface obtenu après amincissement influence directement l'étape de reconstruction de la surface devant accueillir le nano-objet et, notamment, sa rugosité. A cette étape s'ajoute aussi une opération identique pour dégager les TSV utilisés.

Cette seconde technique connue est illustrée par la figure 2 qui est une vue en coupe schématique d'un dispositif comprenant : une couche supérieure 18 pourvue de plots de contact supérieurs 20 à connecter à un nano-objet 22 ; une couche inférieure 24 pourvue de plots de contact inférieurs 26 à connecter à un système électrique externe 28; et une couche de liaison 30 comprenant des vias électriques traversants 32 en contact avec les plots inférieurs; et, entre la couche de liaison et la couche supérieure, au moins deux couches 34, 36 pourvues de lignes conductrices 38 et de vias électriques 40, pour relier les plots supérieurs aux plots inférieurs. La face avant du substrat utilisé est notée 41.

Une troisième approche est connue par le document suivant :

**[3] WO 2014/001920, correspondant à FR 2992 773.**

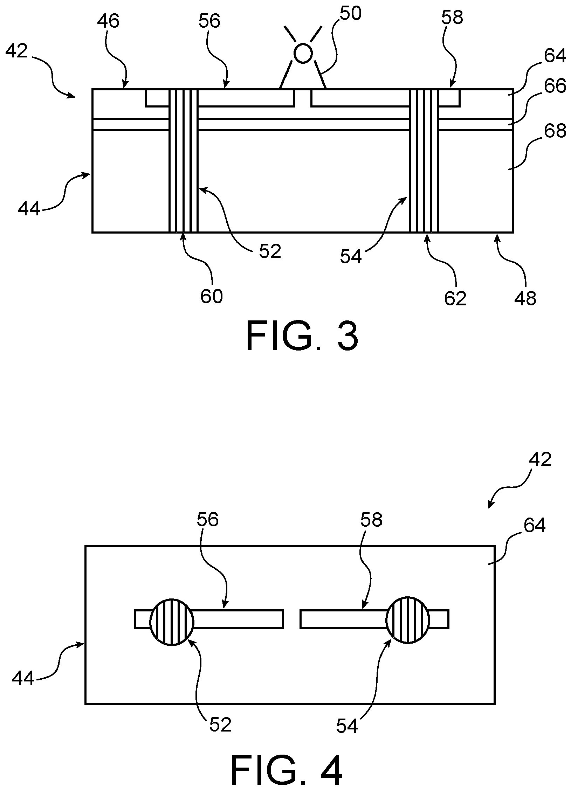

La figure 3 est une vue en coupe schématique d'un mode de réalisation particulier de la structure d'accueil, objet de ce document [3], et la figure 4 est une vue de dessus de ce mode de réalisation particulier.

Cette structure d'accueil, ou interposeur, a la référence 42 sur les figures 3 et 4. Elle est dotée de connexions électriques horizontales, reliées à des connexions électriques verticales. Plus précisément, la structure d'accueil 42, représentée sur les figures 3 et 4, comprend un support 44 dont la face supérieure, ou face avant, a la référence 46 et dont la face inférieure, opposée à la face supérieure, a la référence 48. Cette structure d'accueil 42 est prévue pour connecter électriquement un nano-objet 50 sur la face supérieure 46 et en reprendre le contact électrique sur la face inférieure 48.

La structure d'accueil 42 comprend aussi deux interconnexions de type TSV 52 et 54 qui traversent le support 44 de la face supérieure 46 à la face inférieure 48. Ces faces 46 et 48 comprennent respectivement des zones de reprise de contact pour chacune des interconnexions 52 et 54 : sur la face supérieure 46 (respectivement la face inférieure 48), les zones de reprise de contact associées aux interconnexions 52 et 54 ont respectivement les références 56 et 58 (respectivement 60 et 62).

Dans l'exemple représenté, le support 44 est une multicouche de type semiconducteur sur isolant. Il comprend une couche de silicium résistive 64, formée sur une couche de silice 66, elle-même formée sur un substrat de silicium 68.

Les zones de reprise de contact 56 et 58 sont des zones dopées du support 44. Et chaque zone dopée 56 ou 58 a un motif adapté à l'épanouissement, sur la face supérieure 46 du support 44, de l'interconnexion 52 ou 54 qui lui est associée. La réalisation d'une telle structure d'accueil, où les TSV sont dans le support d'accueil du nano-objet, nécessite le passage par un substrat aminci. En effet, il n'est pas possible à ce jour de réaliser des TSV de dimension ou de coût raisonnables qui traverseraient un support non aminci. Il est donc nécessaire de réaliser l'assemblage du support et d'un capot avant l'amincissement du support, le capot servant de poignée.

Les deux dernières technologies, connues par les documents [2] et [3], nécessitent donc de manipuler le support d'accueil à de nombreuses reprises et de passer par des étapes d'amincissement.

## EXPOSÉ DE L'INVENTION

La présente invention a pour but de remédier aux inconvénients précédents.

On propose, en particulier, une structure d'encapsulation comportant un substrat d'accueil sur lequel au moins un nano-objet est connecté électriquement à des interconnexions qui sont formées dans le plan du substrat (on peut ainsi parler d'interconnexions horizontales) et sont reliées à des vias traversant un capot et débouchant sur lesdites interconnexions, le capot étant rendu solidaire du substrat par l'intermédiaire d'une interface de collage ; chaque interconnexion horizontale est réalisée par assemblage d'une zone dopée du substrat avec un zone dopée du capot; et un via traverse le capot et débouche sur ladite interconnexion.

Avantageusement, le substrat et le capot comprennent une multicouche comportant au moins une couche résistive au niveau de sa face supérieure, la zone dopée étant réalisée dans une partie de l'épaisseur de ladite couche. De préférence, cette couche résistive est une couche semiconductrice d'un support de type SOI.

Les zones dopées présentent chacune un motif adapté à l'épanouissement de l'interconnexion correspondante dans le plan de l'interface de collage et ont une géométrie qui autorise un désalignement entre le substrat et le capot lors de la solidarisation de ces derniers.

De façon précise, la présente invention a pour objet une structure d'encapsulation d'au moins un nano-objet, comprenant :

- un substrat ayant des première et deuxième faces opposées,
- un capot ayant des première et deuxième faces opposées, la première face du capot étant fixée à la première face du substrat,

- au moins une cavité définie entre le capot et le substrat,
- au moins un nano-objet dans la cavité, et
- des premières zones dopées qui sont dans le substrat, au niveau de la première face de celui-ci, le nano-objet étant électriquement relié à au moins deux desdites premières zones dopées,

caractérisée en ce qu'elle comprend en outre :

- des deuxième zones dopées qui sont dans le capot, au niveau de la première face de celui-ci, et qui sont reliées électriquement aux premières zones dopées, et
- des moyens de reprise de contact qui vont de la deuxième face à la première face du capot et débouchent sur les deuxième zones dopées, ces moyens étant reliés électriquement à ces dites deuxièmes zones.

De préférence, les deuxièmes zones dopées sont au moins partiellement en contact direct avec les premières zones dopées.

Selon un premier mode de réalisation particulier de la structure d'encapsulation, objet de l'invention, le substrat est une première multicouche et comprend au moins une première couche résistive au niveau de la première face du substrat, et dans laquelle les premières zones dopées sont formées dans la première couche résistive, sur au moins une partie de l'épaisseur de la première couche résistive.

De préférence, le substrat est de type semiconducteur sur isolant et comporte ainsi une première couche superficielle semiconductrice, et dans laquelle la première couche résistive est constituée par la première couche superficielle semiconductrice.

Selon un deuxième mode de réalisation particulier, le capot est une deuxième multicouche et comprend au moins une deuxième couche résistive au niveau de la première face du capot, et dans laquelle les deuxièmes zones dopées sont formées dans la deuxième couche résistive, sur au moins une partie de l'épaisseur de la deuxième couche résistive.

De préférence, le capot est de type semiconducteur sur isolant et comporte ainsi une deuxième couche superficielle semiconductrice, et dans laquelle la deuxième couche résistive est constituée par la deuxième couche superficielle semiconductrice.

Selon un premier mode de réalisation particulier de l'invention, les moyens de reprise de contact comprennent des vias traversants le capot.

Selon un deuxième mode de réalisation particulier, les moyens de reprise de contact comprennent :

- des trous qui vont en s'évasant des deuxièmes zones dopées à la deuxième face du capot, et
- des fils électriquement conducteurs disposés respectivement dans lesdits trous et qui sont respectivement reliés électriquement aux deuxièmes zones dopées.

En variante, les moyens de reprise de contact peuvent comprendre :

- des trous qui vont en s'évasant des deuxièmes zones dopées à la deuxième face du capot, et
- des pointes de test électriquement conductrices, disposées respectivement dans lesdits trous et adaptées pour être respectivement connectées électriquement aux deuxièmes zones dopées.

De préférence, la première face du capot est fixée à la première face du substrat par collage.

De préférence, le collage est direct.

La présente invention concerne aussi un procédé de fabrication de la structure d'encapsulation, objet de l'invention, dans lequel :

- on forme les premières zones dopées dans le substrat,
- on forme la cavité dans le capot,
- on forme les moyens de reprise de contact dans le capot,
- on forme les deuxièmes zones dopées dans le capot,
- on relie ledit au moins nano-objet auxdites au moins deux premières zones dopées, et
- on assemble et on colle le capot au substrat.

L'ordre des étapes du procédé de fabrication peut-être modifié. En particulier le substrat peut être préparé avant le capot ou vice et versa. Il peut également y avoir des étapes simultanées comme, par exemple, les étapes de formations des zones dopées et/ou les étapes de lissage (préparation de surface).

Selon une caractéristique supplémentaire du procédé de l'invention, après l'étape de réalisation des premières zones dopées et /ou des deuxièmes zones dopées, on effectue une étape de lissage respectivement de ladite première face du substrat et/ou de ladite première face du capot.

Selon une autre caractéristique supplémentaire du procédé de l'invention, le collage est un collage direct.

**BRÈVE DESCRIPTION DES DESSINS**

La présente invention sera mieux comprise à la lecture de la description d'exemples de réalisation donnés ci-après, à titre purement indicatif et nullement limitatif, en faisant référence aux dessins annexés sur lesquels :

- la figure 1 est une vue en coupe schématique d'un support équipé d'interconnexions, divulgué par le document [1] et a déjà été décrite,
- la figure 2 est une vue en coupe schématique d'un exemple du dispositif divulgué par le document [2] et déjà a été décrite,
- la figure 3 est une vue en coupe transversale schématique d'un exemple de la structure d'accueil divulguée par le document [3] et a déjà été décrite,
- la figure 4 est une vue de dessus schématique de cet exemple,
- la figure 5A est une vue en coupe transversale schématique d'un exemple de la structure d'encapsulation, objet de l'invention,
- la figure 5B est une vue de dessus schématique de l'exemple de la figure 5A,
- la figure 6 est une vue en coupe transversale schématique d'une variante de cet exemple,
- la figure 7 est une vue en coupe transversale schématique d'une autre variante de cet exemple,
- la figure 8 est une vue en coupe transversale schématique d'une variante du substrat utilisé dans l'exemple de la figure 6,
- les figures 9A à 9D sont des vues de dessus schématiques de divers motifs possibles pour les zones dopées du substrat utilisé dans l'invention,
- les figures 10 et 11 sont des vues de dessus schématiques de structures conformes à l'invention, comportant des zones dopées dont les géométries ou les tailles sont différentes, et
- les figures 12 et 13 illustrent schématiquement les problèmes d'alignement susceptibles de se poser pour ces zones dopées.

**EXPOSÉ DÉTAILLÉ DE MODES DE RÉALISATION PARTICULIERS**

On donne ci-après divers exemples de la présente invention, dans lesquels la structure d'encapsulation est composée d'un substrat et d'un capot, tous deux en matériau semiconducteur dans ces exemples, et avantageusement en silicium, en vue de protéger un ou des nano-objets et de relier électriquement ces derniers de la face avant du substrat, à la face arrière du capot, en utilisant uniquement des technologies de la microélectronique pour réaliser un épanouissement des contacts électriques de la face avant du substrat vers la face arrière du capot, tout en limitant au strict minimum les opérations sur le substrat.

La face avant du substrat a généralement un état de surface compatible avec l'accueil d'un ou de nano-objet(s) ce qui permet avantageusement de réaliser un assemblage direct entre le substrat et le capot par collage direct, lorsque ce dernier a également un état de surface compatible avec cet assemblage direct.

Les lignes électriques sur la face avant du substrat et la face avant du capot sont réalisées sur un substrat semiconducteur, avantageusement de type SOI (pour « Silicon On Insulator »), selon des zones dopées et des vias qui traversent le capot et débouchent sur lesdites zones dopées, afin de pouvoir reprendre les contacts et les ramener sur la face arrière du capot. Les géométries des lignes et des vias sont adaptées pour autoriser un désalignement entre eux lors de la solidarisation du capot au substrat.

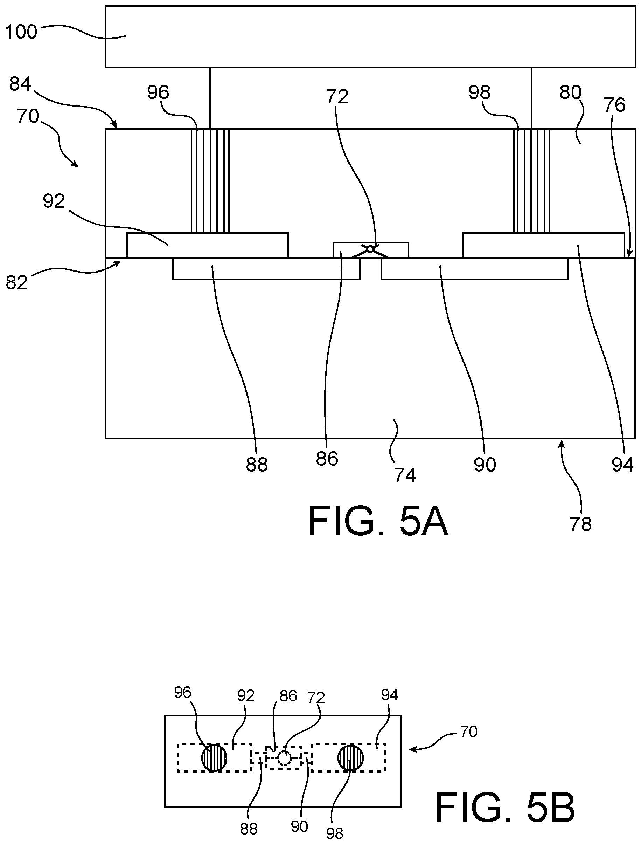

La figure 5A est une vue en coupe transversale schématique d'un premier mode de réalisation particulier de la structure d'encapsulation, objet de l'invention. Et la figure 5B est une vue de dessus schématique de ce premier mode de réalisation particulier.

La structure 70, représentée sur les figures 5A et 5B, est destinée à encapsuler un nano-objet 72 et comprend un substrat 74 ayant une première face 76, ou face avant, et une deuxième face 78, ou face arrière, opposée à la face avant 78. La structure 70 comprend aussi un capot 80 ayant une première face 82, ou face avant, et une deuxième face 84, ou face arrière, opposée à la face avant 82.

La face avant 82 du capot 80 est fixée à la face avant 76 du substrat 74. Dans l'exemple décrit, ces faces 76 et 82 sont collées l'une à l'autre.

La structure 70 comprend aussi une cavité 86 qui est définie entre le capot 80 et le substrat 74. Dans l'exemple décrit, elle est prévue dans le capot 80, comme on le voit. Le nano-objet 72 est dans cette cavité 86.

Des zones dopées 88 et 90 sont formées dans le substrat 74, au niveau de la face avant 76 de celui-ci. Le nano-objet est électriquement relié aux zones 88 et 90, comme on le voit sur la figure 5A.

La structure 70 comprend en outre d'autres zones dopées 92 et 94 qui sont formées dans le capot 80, au niveau de la face avant 82 de celui-ci. Ces zones 92 et 94 sont respectivement, et au moins partiellement, en contact direct avec les zones 88 et 90.

La structure 70 comprend également des moyens de reprise de contact 96, 98 qui vont de la face avant à la face arrière du capot 80 et débouchent respectivement sur les zones dopées 92 et 94. Comme on le voit sur la figure 5A, ces moyens de reprise de contact permettent, par exemple, de connecter le nano-objet 72 à un système électrique externe approprié 100, en vue d'effectuer des mesures électriques sur le nano-objet 72.

Dans l'exemple représenté sur les figures 5A et 5B, ces moyens de reprise de contact 96 et 98 sont des vias traversants.

On précise en outre que, dans l'exemple représenté sur les figures 5A et 5B, le substrat 74 et le capot 80 sont faits d'un matériau semiconducteur et solidarisés par un collage direct semiconducteur/semiconducteur selon leurs faces avant. Par « collage direct », il faut entendre un collage sans apport de colle, qui est effectué simplement par liaisons interatomiques entre les faces en contact. Les zones 88, 90, 92, 94 sont dopées par implantation et activation des dopants. Les zones 92 et 94 sont respectivement connectées électriquement aux vias 96 et 98 qui débouchent sur la face arrière du capot.

Dans un deuxième exemple, le substrat 74 est une multicouche comprenant au moins une couche résistive au niveau de sa face avant. Et les zones dopées 88 et 90 sont formées dans cette couche résistive, sur au moins une partie de l'épaisseur de celle-ci. Alors, on utilise par exemple un substrat 74 de type semiconducteur sur isolant, comportant ainsi une couche superficielle semiconductrice, constituant la couche résistive mentionnée plus haut.

Dans un troisième exemple, le capot 80 est une multicouche comprenant au moins une couche résistive au niveau de sa face avant. Et les zones dopées 92 et 94 sont formées dans cette couche résistive, sur au moins une partie de l'épaisseur de celle-ci. Alors, on utilise par exemple un capot 80 de type semiconducteur sur isolant, comportant ainsi une couche superficielle semiconductrice, constituant la couche résistive susmentionnée.

Dans un quatrième exemple, on combine les deuxième et troisième exemples : le substrat 74 est tel que décrit dans le deuxième exemple et le capot 80 est tel que décrit dans le troisième exemple.

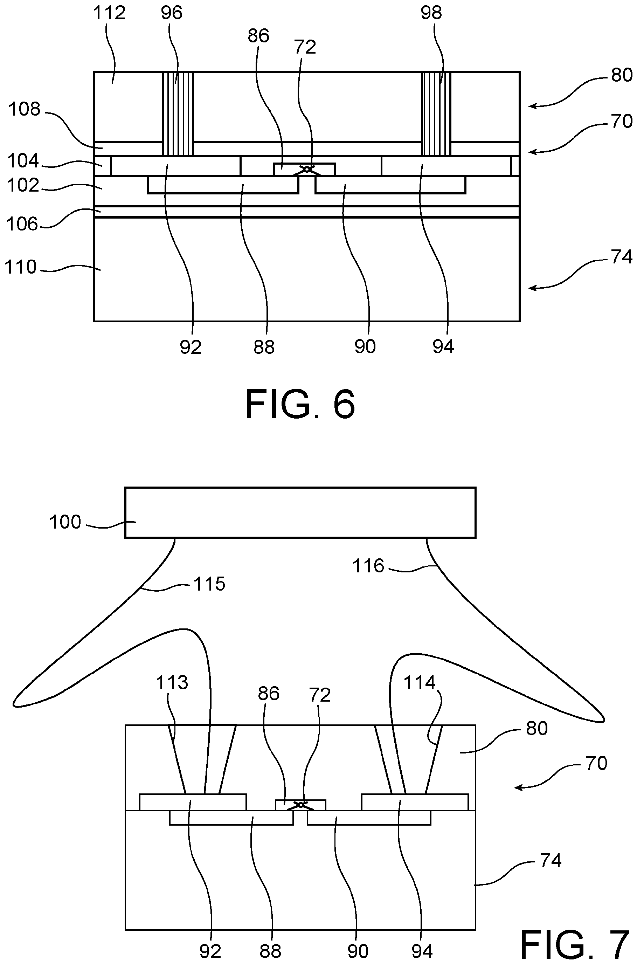

Ce quatrième exemple est schématiquement illustré par la vue en coupe transversale de la figure 6.

Dans le cas de cette figure 6, le substrat 74 et le capot 80 sont de type SOI : comme on le voit, le substrat 74 (respectivement le capot 80) comprend une couche mince de silicium 102 (respectivement 104), une couche d'isolation 106 (respectivement 108) de type BOX (pour « burried oxide ») et une couche épaisse de silicium 110 (respectivement 112). Les zones déposées 88, 90 (respectivement 92, 94) sont donc situées au-dessus de la couche d'isolation 106 (respectivement 108), comme on le voit sur la figure 6.

Et l'on peut combiner les structures représentées sur les figures 5A et 6 de façon à avoir un substrat 74 en SOI et un capot 80 standard, et inversement, comme on l'a déjà expliqué plus haut.

Un autre exemple de l'invention est schématiquement illustré par la vue en coupe transversale de la figure 7. Dans cet autre exemple, les moyens de reprise de contact comprennent :

- des trous 113 et 114 qui vont en s'évasant des zones dopées 92 et 94 jusqu'à la face arrière 84 du capot 80, et
- des fils électriquement conducteurs 115 et 116 qui traversent les trous 113 et 114 et sont respectivement fixés aux zones dopées 92 et 94, comme on le voit sur la figure 7.

Les fils 115 et 116 peuvent être par exemple reliés au système 100 mentionné plus haut, pour faire des mesures.

Dans l'invention, on peut donc reprendre directement le contact sur les zones dopées du capot au travers des trous 113 et 114. Et, dans l'exemple de la figure 7, le contact est repris au moyen des fils électriquement conducteurs 115 et 116, selon la technique de soudage par boule (en anglais, *bail bonding*), couramment utilisée en microélectronique.

On peut aussi imaginer des pointes de test (non représentées) pour réaliser une mesure électrique sur le circuit défini par l'ensemble des interconnexions et le nano-objet. Ces pointes de test remplacent alors les fils 115 et 116 et sont adaptées pour être respectivement connectées aux zones dopées 92 et 94 à travers les trous 113 et 114.

On précise que la cavité 86 peut contenir plus d'un nano-objet. On peut également prévoir plus d'une cavité, chaque cavité contenant un ou plusieurs nano-objets. Dans tous les cas, on prévoit autant de zones dopées, dans le substrat et le capot, et de vias (ou de fils conducteurs) que nécessaire afin de pouvoir connecter les nano-objets utilisés et faire les mesures envisagées sur ces derniers.

On calcule ci-après la résistance électrique de la chaîne des conducteurs 96-92-88 ou 98-94-90 :

Compte tenu du fait que les contacts électriques vont en se rétrécissant au fur et à mesure que l'on se rapproche du nano-objet, la résistance de la de ligne dependra, en première approximation, uniquement de la partie de section la plus faible (88 ou 90).

EP 3 007 218 B1

On note C l'élément 96 ou 98, B l'élément 92 ou 94 et A l'élément 88 ou 90. On note $\rho_i$ la résistivité du matériau constituant l'élément i et $l_i$ (largeur) et $L_i$ (longueur) ses dimensions dans le plan constitué par la face avant du substrat, lorsque l'élément conducteur est de section rectangulaire (cas de A et B), $r_i$ son rayon lorsqu'il est cylindrique (cas de C) et $H_i$ sa hauteur selon un axe perpendiculaire au plan mentionné ci-dessus. La résistance électrique totale est donc égale à R, avec $R=R_A+R_B+R_C$, où les résistances correspondent à chacun des éléments individuels de la ligne.

$$R_A=\rho_A. L_A/(l_A. H_A)$$

$$R_B=\rho_B. L_B/(l_B. H_B)$$

$$R_C=\rho_C.L_C/(\pi. r_C^2)$$

Les valeurs numériques, utilisées pour les divers éléments, sont données dans le tableau 1 :

Tableau 1

| Elément | Longueur min | Longueur max | Largeur min | Largeur max | Hauteur min | Hauteur max |
|---|---|---|---|---|---|---|
| A | $50\mu m$ | $500\mu m$ | 10 nm | $1\ \mu m$ | 10nm | $5\mu m$ |
| B | $50\ \mu m$ | 1mm | $1\mu m$ | $100\mu m$ | 10nm | $5\ \mu m$ |
| | | | Rayon min | Rayon max | | |
| C | | | $10\mu m$ | $100\ \mu m$ | $50\ \mu m$ | $700\mu m$ |

Dans le cas où tous les éléments ont la même résistivité, notée $\rho$, et $H_A$ et $H_B$ ont la même valeur, notée H, on peut effectuer le calcul de $R/R_A$. L'application numérique est faite à partir des valeurs qui sont données dans le Tableau 2 :

Tableau 2

| IA | LA | IB | LB | H | rC | HC | $R/R_A$ |
|---|---|---|---|---|---|---|---|
| 0,1 | 100 | 10 | 200 | 1 | 10* | 50 | 1,02 |
| 0,1 | 100 | 1 | 1 | 1 | 1 | 1 | 1,00 |
| (*) Comme les TSV sont composés de tubes concentriques, l'exemple numérique considéré ici correspond à peu près à un tube de rayon intérieur $7\mu m$ et de rayon extérieur 12 $\mu m$. | | | | | | | |

On voit donc que la résistance électrique totale dépend essentiellement de celle de l'élément A, dont la section est inférieure à celle des deux autres.

Cependant, on veillera à ce que les surfaces de recouvrement entre les différentes zones dopées, notamment la surface de recouvrement de A par B, soient suffisantes pour ne pas impacter la résistance de la ligne constituée par l'ensemble des zones dopées. Pour ce faire, on prendra une marge suffisante, avec par exemple un rapport de surfaces B/A de 5 à 10 fois la plus petite section conductrice, c'est-à-dire celle de la zone dopée A. Cette valeur sera aussi ajustée en fonction du désalignement qui sera toléré lors de l'assemblage, car ce désalignement modifiera la surface de recouvrement.

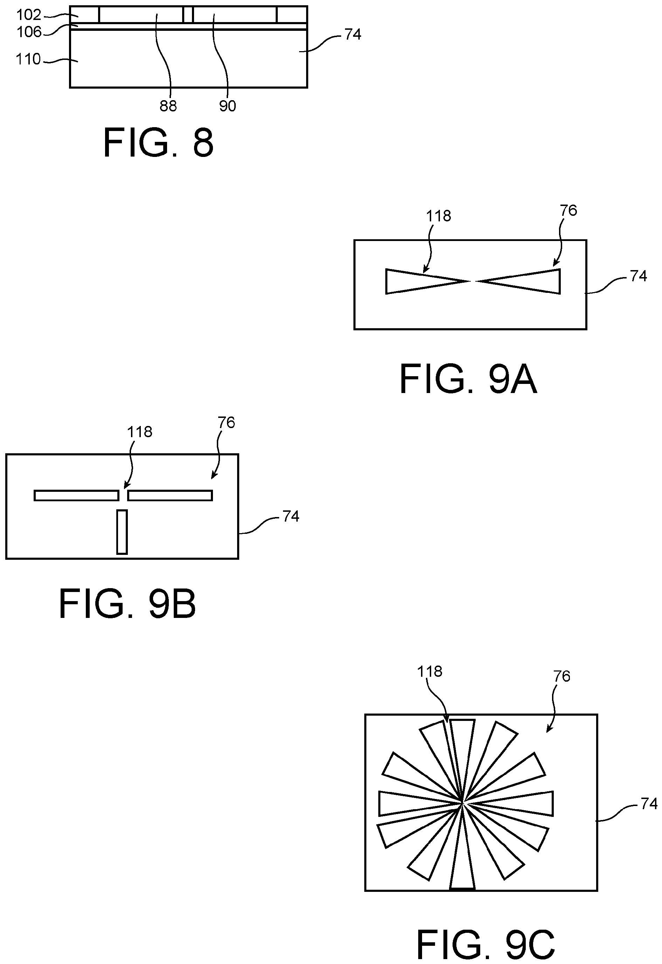

La figure 8 illustre schématiquement une variante du substrat 74 représenté sur la figure 6. Dans cette variante, les zones dopées 88 et 90 s'arrêtent sur le BOX 106.

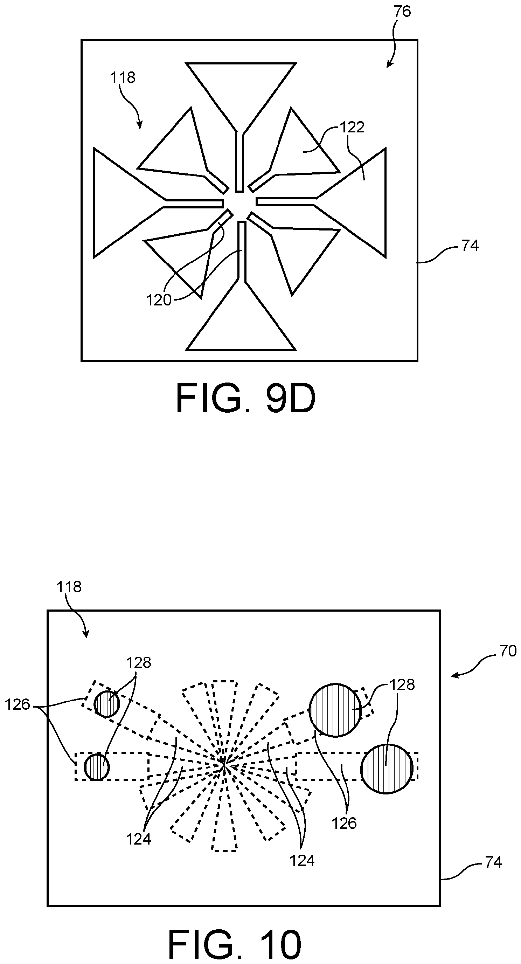

Les figures 9A, 9B, 9C et 9D sont des vues de dessus schématiques de la face avant du substrat 74, montrant diverses variantes pour la géométrie des zones dopées, associées au substrat. Sur ces figures, l'ensemble de ces zones dopées a la référence 118.

On note que la variante illustrée par la figure 9D comporte deux jeux de « lignes » dopées. Chacune de ces « lignes » est constituée d'une partie rectangulaire 120 et d'une partie évasée 122. Les parties 120 sont disposées en étoile, de façon à disposer d'un maximum de contacts dans la partie centrale. Selon cette répartition, il est donc possible d'augmenter la taille des parties 122, tout en gardant un motif de section identique pour la partie 120 de toutes les « lignes » avec une longueur qui varie selon les motifs et donc une augmentation de la résistance électrique proportionnellement à la longueur.

La figure 10 est une vue de dessus schématique d'une structure 70 pour laquelle les zones dopées du substrat 74, notées ici 124, ont la même géométrie. Sur la partie gauche de la figure 10, les zones dopées du capot, notées ici 126, ont les mêmes dimensions et les TSV, notés ici 128, ont le même diamètre. Sur la partie droite, les zones dopées 126 ont des longueurs différentes, ce qui permet de choisir, pour les TSV, un diamètre supérieur à celui qu'ils ont sur la partie gauche.

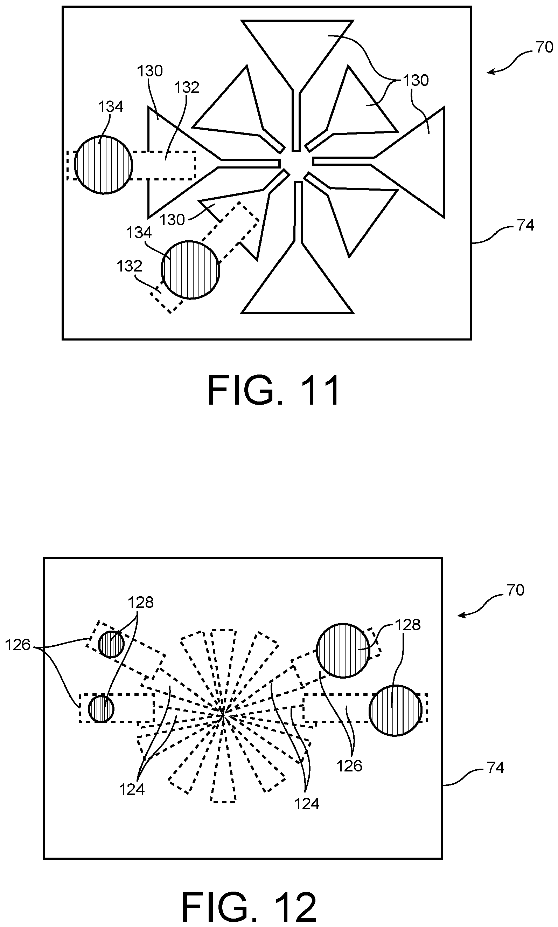

La figure 11 est une vue de dessus schématique d'une structure 70 sur laquelle les zones dopées du substrat 74, ici notées 130, ont des géométries différentes. Les zones dopées du capot, ici notées 132, ont les mêmes dimensions et il en est de même pour les TSV, ici notés 134.

La figure 12 est une vue de dessus schématique d'un exemple de structure 70, dans lequel les zones 124 et 126 ne sont pas parfaitement alignées, par comparaison avec la figure 10 (sur la figure 12, on a repris les mêmes références que sur la figure 10).

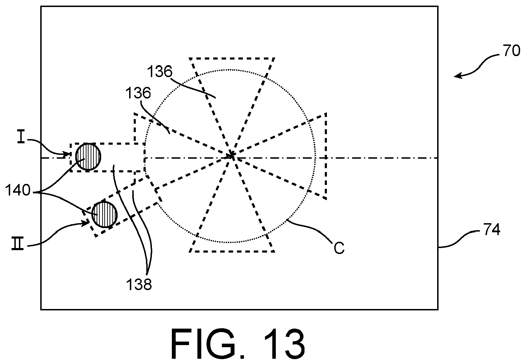

La figure 13 est une vue de dessus schématique d'un exemple de structure 70, dans lequel les zones dopées 136, correspondant au substrat 74, et les zones dopées 138, correspondant au capot (les vias correspondants ont la référence 140) ne sont pas parfaitement alignées (faire une comparaison entre la position I et la position II).

Soit $\underline{n}$ le nombre de secteurs qui définissent n/2 zones 136 (n=8 dans le cas de la figure 13). Les zones dopées 138 recouvrent les zones dopées 136 à partir de la zone délimitée par un cercle C de rayon R. Soit L la largeur des zones 138, telle que $L \leq \pi R/n$. En faisant l'hypothèse que la zone de recouvrement minimale vaut L/2, on calcule aisément le désalignement autorisé (entre la position I et la position II) en rotation autour d'un axe perpendiculaire au substrat 74 et situé au centre du cercle C de rayon R. Ce désalignement est égal à $\pi R/(2n)$.

On donne ci-après divers avantages liés à l'invention.

1- La structure 70 peut être réalisée uniquement en silicium, oxyde de silicium et dopants classiques (de type N ou P) du silicium, typiquement à partir de deux plaquettes en silicium et avantageusement en SOI (il sera avantageux de prendre le même SOI pour les deux plaquettes). Dans une variante, on peut envisager des substrats composés d'une première couche de silicium monocristallin de haute résistivité, sous laquelle est disposée le BOX.

2- Pour le silicium, les deux composants (substrat et capot) de la structure 70 peuvent être portés à une température compatible avec une reconstruction atomique de leurs faces avant respectives, typiquement comprise entre 950°C et 1100°C.

3- Les lignes de connexion dessinées par dopage ne perturbent pas la reconstruction de surface nécessaire au dépôt des nano-objets.

4- Le dessin des zones dopées et le contrôle de la diffusion des dopants doivent permettre de rapprocher les zones dopées à une distance allant de quelques nanomètres à quelques dizaines de nanomètres. Il est donc nécessaire d'écarter les extrémités des zones implantées d'au moins deux fois la distance de diffusion pour obtenir finalement des zones électriquement conductrices, distantes de quelques nanomètres. Ces dimensions sont compatibles avec les outils de photolithographie qui vont permettre de définir les zones à implanter.

5- Le dessin de la zone globale à implanter peut être défini selon plusieurs géométries et de façon à contrôler au mieux le profil de diffusion des dopants.

6- Pour le substrat 74, il n'est pas utile de contrôler la profondeur d'implantation. Dans le cas d'un substrat de type SOI, les zones dopées peuvent aller jusqu'au BOX. On peut donc, dans ce cas, réaliser les étapes d'implantation du substrat et du capot au cours d'un même procédé.

7- Les TSV sont avantageusement réalisés en silicium et dopés préalablement au traitement de reconstruction de surface qui permet ainsi d'homogénéiser leur dopage.

8- Compte tenu du fait que la surface des de chacune des deux plaquettes est reconstruite et rendue hydrophobe, il est possible d'assembler le capot 80 sur le substrat 74 par collage direct. Il est aussi possible de profiter de cet état de surface pour réaliser un collage temporaire avec une plaquette faite du même matériau que celui qui constitue la plaquette à protéger.

On décrit ci-après un exemple de procédé de réalisation de la structure d'encapsulation, objet de l'invention.

Les matériaux constituant le substrat et le capot sont faits de matériaux semiconducteurs. Les zones dopées leur correspondant sont obtenues par dopage de ces matériaux. Afin d'obtenir une conduction de type ohmique au travers de l'interface créée lors de l'assemblage des zones dopées correspondant au capot sur les zones dopées correspondant au substrat, il est nécessaire de doper les deux matériaux selon le même type de dopage, à savoir $\underline{n}$ ou $\underline{p}$. Afin de ne pas générer de défaut de conduction à l'interface, les surfaces sont désoxydées, et les deux matériaux sont donc assemblés après un traitement qui rend les surfaces hydrophobes.

On se reportera au document suivant :

O. Engström, S. Bengstsson, G.I. Andersson et A. Jauhiainen, J. Electrochem. Soc., Vol. 139, No. 12, December 1992**.**

On y décrit des caractérisations électriques pour un assemblage nSi/nSi.

On se reportera également au document suivant :

S. Essig et F. Dimroth, ECS Journal of Solid State Science and Technology, 2 (9) Q178-Q181 (2013**).**

On y décrit des caractérisations électriques pour un assemblage, par exemple, nSi/nGaAs. Dans ce dernier cas, les deux matériaux semiconducteurs sont donc de natures différentes. Cela signifie aussi que l'on peut par exemple réaliser des TSV en polysilicium dopé, déposé par CVD (dépôt chimique en phase vapeur) dans un capot fait, par exemple, de Si, de nature différente de celle du substrat, par exemple GaAs. Le dopage du silicium déposé par CVD peut être de type $\underline{n}$ ou $\underline{p}$. Le dépôt par CVD de polysilicium dopé est effectué à une température proche 600°C ; il faut donc choisir pour le capot des matériaux semiconducteurs qui vont être capables de supporter une telle température.

On choisira de préférence des semiconducteurs ayant une forte résistivité (supérieure à environ $10^3$ ohm.cm) de façon à éviter l'isolation des TSV.

Dans le cas d'un substrat et/ou d'un capot en SOI, on choisit avantageusement des SOI en silicium.

Les SOI qui seront utilisés ont de préférence les caractéristiques suivantes :

-   épaisseur de la couche de silicium sur la face avant : de quelques dizaines de nanomètres à quelques dizaines de micromètres et, dans ce cas, elle est en silicium de haute résistivité, typiquement quelques $10^3$ ohm.cm, afin de conserver une isolation électrique entre les différentes zones dopées.

Lorsque le substrat est en SOI, la couche située sous le BOX peut être faite d'un autre matériau que le silicium (par exemple un verre, une céramique ou un métal), puisque cette couche n'a pas de fonction particulière, si ce n'est le fait de constituer un support mécanique.

-   épaisseur du BOX : de quelques dizaines de nanomètres à quelques micromètres.

On explique maintenant la réalisation du substrat. Les étapes de fabrication sont les suivantes :

1s-Dépôt du masque d'implantation sur la face avant du substrat (ce masque est par exemple en oxyde ou en nitrure de silicium, et son épaisseur est de l'ordre de 1 $\mu$m ou moins, selon la résolution cherchée et la dose à implanter), en vue de former les zones dopées correspondantes.

2s-Photolithographie et gravure du masque.

3s-Implantation des dopants.

4s-Retrait du masque.

5s-Préparation de la surface de la face avant du substrat : le lissage de la surface, qui consiste à réduire sa rugosité avantageusement à l'échelle atomique, se fait généralement par un traitement thermique à haute température. Par exemple pour le silicium, le traitement thermique est effectué sous une pression partielle d'hydrogène à une température comprise entre environ 950°C et 1100°C pendant quelques minutes. On peut aussi profiter de ce traitement thermique pour faire diffuser les dopants. La surface ainsi obtenue est de nature hydrophobe.

6s-On peut ensuite éventuellement protéger cette surface par un capot temporaire qui est préparé selon le même procédé et sera assemblé par collage direct sur le substrat.

7s-On forme le nano-objet sur le substrat et on le relie aux zones dopées associées (si la surface a été protégée par le report d'un capot temporaire, ce dernier est retiré au préalable à l'opération de placement du nano-objet).

8s- On protège éventuellement et temporairement le nano-objet par un procédé identique à l'étape 6s, en attendant le report du capot final équipé des connexions électriques (on notera qu'une cavité aura été réalisée, par exemple par usinage dans ce capot temporaire, selon une étape 0c qui sera décrite ultérieurement, au préalable à son lissage de surface).

On explique à présent la réalisation du capot.

Les TSV sont réalisés avant l'assemblage du capot au substrat.

**Option I.** Cas où les TSV sont réalisés à partir de la face avant du capot.

Les étapes de fabrication sont les suivantes :

0c -Réalisation de la cavité 86 selon un procédé classique de photolithographie et gravure.

1c-Réalisation des TSV 96, 98 selon un procédé de photolithographie et de gravure ionique réactive profonde (DRIE pour « Deep Reactive Ion Etching ») du silicium, à partir de la face avant du capot. Les vias seront avantageusement définis selon une géométrie en tube, d'épaisseur égale à quelques micromètres (3 $\mu$m à 5 $\mu$m par exemple). De manière optionnelle et afin de réduire la résistance électrique du via descendant, plusieurs tubes concentriques (par exemple trois tubes concentriques) seront réalisés; on partira par exemple d'un tube de 10 $\mu$m de diamètre intérieur, qui pourra ensuite être entouré de deux autres tubes ayant des diamètres intérieurs respectivement égaux à 30 $\mu$m et 50 $\mu$m, pour une épaisseur de silicium dopé déposé par CVD, égale à 5 $\mu$m.

Il convient de noter que pour un SOI, il faudra graver le semiconducteur puis le BOX et enfin le matériau de support du BOX, matériau qui sera avantageusement fait d'un matériau identique à celui de la première couche gravée. Avantageusement, on utilisera du silicium. Dans la configuration où la zone dopée atteint le BOX, on pourra réaliser des TSV dans un support non-isolant, mais il sera alors nécessaire de les isoler selon l'opération suivante : on procédera à l'isolation des TSV par dépôt d'une couche d'oxyde de semiconducteur (épaisseur comprise entre 100 nm et environ 1 $\mu$m), selon un traitement thermique d'oxydation du semiconducteur ou un dépôt par CVD d'un oxyde.

2c- Remplissage des vias verticaux par un procédé de dépôt par CVD de silicium polycristallin dopé, c'est-à-dire par dépôt chimique en phase vapeur (en anglais, *chemical vapor deposition*). Dans une variante, on peut utiliser du tungstène déposé par CVD ou, plus généralement, tout métal compatible avec le traitement thermique de l'étape 8c, mais aussi avec le semiconducteur dopé, car il faut veiller à maintenir un contact ohmique entre les deux éléments.

3c- Polissage mécano-chimique (CMP) pour retirer le silicium déposé sur la face avant et si nécessaire sur la face arrière.

Il convient de noter que dans le cas les TSV ont été isolés, il est nécessaire de graver l'oxyde d'isolation sur une hauteur équivalente à celle de la zone dopée, afin de faciliter le passage du courant. Dans ce cas, on bouche les trous créés par un nouveau dépôt de polysilicium dopé et l'on refait un polissage mécano-chimique.

4c- Dépôt du masque d'implantation (par exemple fait d'oxyde ou de nitrure de silicium et ayant une épaisseur de l'ordre de 1 $\mu$m ou moins, selon la résolution cherchée et la dose à implanter), en vue de former les zones dopées correspondantes.

5c- Photolithographie et gravure du masque.

6c-Implantation des dopants. Le dopage est de même type que celui des TSV, ou lorsqu'ils sont métalliques, tel qu'il permette une conduction ohmique entre les TSV et les zones dopées.

7c-Retrait du masque.

8c-Préparation de la surface de la face avant du capot : le lissage de la surface, qui consiste à réduire sa rugosité à l'échelle atomique se fait généralement par un traitement thermique à haute température. Par exemple pour le silicium, le traitement thermique est effectué sous une pression partielle d'hydrogène à une température comprise entre environ 950°C et 1100°C pendant quelques minutes. On peut aussi profiter de ce traitement thermique pour faire diffuser les dopants. La surface ainsi obtenue est de nature hydrophobe.

9c-Protection temporaire de la face avant par collage direct d'une poignée, avantageusement constituée du même matériau que le capot et traitée selon l'étape 8c.

10c-Réduction de l'épaisseur du capot par sa face arrière (par meulage (en anglais, *grinding*) puis CMP) pour dégager les TSV. Pour les TSV envisagés, le rapport de forme (profondeur divisée par épaisseur) est de l'ordre de 30, d'où typiquement une épaisseur de silicium d'environ 100 $\mu$m à 150 $\mu$m pour des épaisseurs de silicium dopé déposé de 3 $\mu$m à 5 $\mu$m).

11c-Retrait de la protection temporaire avant assemblage avec le substrat. Il convient de noter que l'on pourrait aussi effectuer une autre séquence de fabrication dans laquelle l'ordre des étapes serait le suivant : 4c-5c- 6c-7c-0c-1c-2c-3c-8c-9c-10c-11c.

Pour l'assemblage et le collage du capot au substrat, on utilise les étapes suivantes :

1a-Alignement du capot par rapport au substrat. Cette opération est réalisée au moyen d'un aligneur classiquement utilisé en technologie MEMS.

2a-Assemblage et collage du capot au substrat par mise en contact de leurs faces avant respectives, lesdites faces devant avoir des états de surfaces compatibles avec un collage direct (par exemple ces faces ont une rugosité atomique. Avantageusement, l'opération d'assemblage sera faite sous atmosphère contrôlée.

**Option II.** Cas où les TSV sont réalisés à partir de la face arrière du capot.

Les étapes de fabrication sont les suivantes :

On reprend les opérations 0c et 4c à 9c de l'option I de la préparation du capot. Après assemblage avec une poignée temporaire 9c, c'est la poignée qui sert alors de support mécanique au capot qui sera ensuite usiné sur sa face arrière selon les étapes 1c ,10c et 11c de la fabrication du capot. On procède ensuite aux étapes de remplissage (étape 2c) et de polissage (étape 3c) avant de procéder à un nouveau lissage de la surface (étape 8c).

On indique ci-après comment modifier le procédé dans le cas de la figure 7, où les TSV sont remplacés par des fils traversant des trous. On procède d'abord aux étapes 4c à 6c. Ces trous sont ensuite avantageusement réalisés selon un procédé photolithographie et par gravure anisotrope du capot selon sa face arrière. Pour ce faire on utilise un bain de TMAH (Triméthyl Ammonium Hydroxyde) pour graver du silicium. Il s'agit d'un procédé connu de l'homme du métier. Il est avantageux car il permet de réaliser des cavités très profondes, de plusieurs centaines de microns dans du silicium. La gravure sera arrêtée par la couche d'oxyde dans le cas d'un SOI. On procède ensuite à une gravure par voie sèche ou humide de la couche de SOI afin de dégager les zones implantées. Enfin après retrait des masques d'implantation et de gravure, on procède à l'étape de lissage de surface (étape 8c) avant d'assembler le capot au substrat (étapes 1a et 2a).

Afin de bénéficier d'un contact ohmique entre la zone dopée et un conducteur électrique tel que un fil ou une pointe de test électrique, on dépose un premier métal dans le fond des trous. On choisira un métal qui est en accord avec le type de dopant de façon à assurer une conduction de type ohmique. Au préalable à ce dépôt on procède avantageusement à un décapage des zones dopées apparentes en fond du trou de façon à éliminer tout oxyde natif qui augmenterait la résistance de contact entre le conducteur et la zone dopée. On peut ensuite déposer un second métal et avantageusement à base d'or, de cuivre ou d'aluminium si on souhaite connecter avec des fils d'or ou de cuivre sur ces mêmes zones par la technique de « bail bonding ».

On remarquera que selon des procédés de dépôts dans les trous (par exemple au travers d'un pochoir pour ne pas avoir à faire de lithographie), on peut aussi remonter les contacts électriques sur la face arrière du capot pour peu que l'on ait déposé, au préalable, un isolant électrique sur les flancs des trous.

**Revendications**

1. Structure d'encapsulation d'au moins un nano-objet, comprenant :

   - un substrat (74, 102-106-110) ayant des première et deuxième faces opposées,
   - un capot (80, 104-108-112) ayant des première et deuxième faces opposées, la première face du capot étant fixée à la première face du substrat,
   - au moins une cavité (86) définie entre le capot et le substrat,
   - au moins un nano-objet (72) dans la cavité, et
   - des premières zones dopées (88-90, 118, 124, 130, 136) qui sont dans le substrat, au niveau de la première face de celui-ci, le nano-objet étant électriquement relié à au moins deux desdites premières zones dopées,

   **caractérisée en ce qu'**elle comprend en outre :

   - des deuxième zones dopées (92-94, 126, 132, 138) qui sont dans le capot, au niveau de la première face de celui-ci, et qui sont reliés électriquement aux premières zones dopées, et
   - des moyens de reprise de contact (96-98, 113-114-115-116, 128, 134, 140) qui vont de la deuxième face à la première face du capot et débouchent sur les deuxièmes zones dopées , ces moyens étant reliés électriquement à ces dites deuxièmes zones.

2. Structure d'encapsulation selon la revendication 1, dans laquelle les deuxièmes zones dopées (92-94, 126, 132, 138) sont au moins partiellement en contact direct avec les premières zones dopées.

3. Structure d'encapsulation selon la revendication 1 ou 2, dans laquelle le substrat (74) est une première multicouche (102, 106, 110) et comprend au moins une première couche résistive (102) au niveau de la première face du substrat, et dans laquelle les premières zones dopées (88, 90) sont formées dans la première couche résistive, sur au moins une partie de l'épaisseur de la première couche résistive.

4. Structure d'encapsulation selon la revendication 3, dans laquelle le substrat (74) est de type semiconducteur sur isolant et comporte ainsi une première couche superficielle semiconductrice (102), et dans laquelle la première couche résistive est constituée par la première couche superficielle semiconductrice.

5. Structure d'encapsulation selon l'une quelconque des revendications 1 à 4, dans laquelle le capot (80) est une deuxième multicouche (104, 108, 112) et comprend au moins une deuxième couche résistive (104) au niveau de la première face du capot, et dans laquelle les deuxièmes zones dopées (92, 94) sont formées dans la deuxième couche résistive, sur au moins une partie de l'épaisseur de la deuxième couche résistive.

**6.** Structure d'encapsulation selon la revendication 5, dans laquelle le capot (80) est de type semiconducteur sur isolant et comporte ainsi une deuxième couche superficielle semiconductrice (104), et dans laquelle la deuxième couche résistive est constituée par la deuxième couche superficielle semiconductrice.

**7.** Structure d'encapsulation selon l'une quelconque des revendications 1 à 6, dans laquelle les moyens de reprise de contact comprennent des vias traversants (96-98, 128, 134, 140) le capot.

**8.** Structure d'encapsulation selon l'une quelconque des revendications 1 à 6, dans laquelle les moyens de reprise de contact comprennent :

- des trous (113, 114) qui vont en s'évasant des deuxièmes zones dopées (92, 94) à la deuxième face du capot (80), et
- des fils électriquement conducteurs (115, 116) disposés respectivement dans lesdits trous et qui sont respectivement reliés électriquement aux deuxièmes zones dopées (92, 94).

**9.** Structure d'encapsulation selon l'une quelconque des revendications 1 à 6, dans laquelle les moyens de reprise de contact comprennent :

- des trous (113, 114) qui vont en s'évasant des deuxièmes zones dopées (92, 94) à la deuxième face du capot (80), et
- des pointes de test électriquement conductrices, disposées respectivement dans lesdits trous et adaptées pour être respectivement connectées électriquement aux deuxièmes zones dopées (92, 94).

**10.** Structure d'encapsulation selon l'une quelconque des revendications 1 à 9, dans laquelle la première face du capot (80) est fixée à la première face du substrat (74) par collage.

**11.** Structure d'encapsulation selon la revendication 10, dans laquelle le collage est direct.

**12.** Procédé de fabrication de la structure d'encapsulation selon l'une quelconque des revendications 1 à 11, dans lequel :

- on forme les premières zones dopées (88, 90) dans le substrat (74),
- on forme la cavité (86) dans le capot (80),
- on forme les moyens de reprise de contact (96, 98) dans le capot,
- on forme les deuxièmes zones dopées (92, 94) dans le capot (80),
- on relie ledit au moins nano-objet (7) auxdites au moins deux premières zones dopées (88, 90), et
- on assemble et on colle le capot (80) au substrat (74).

**13.** Procédé de fabrication de la structure d'encapsulation selon la revendication 12 dans lequel, après l'étape de réalisation des premières zones dopées et /ou des deuxièmes zones dopées, on effectue une étape de lissage respectivement de ladite première face du substrat (74) et/ou de ladite première face du capot (80).

**14.** Procédé de fabrication de la structure d'encapsulation selon l'une des revendications 12 ou 13, dans lequel le collage est un collage direct.

**Patentansprüche**

**1.** Struktur zur Einkapselung wenigstens eines Nanoobjekts, umfassend:

- ein Substrat (74, 102-106-110), das erste und zweite entgegengesetzte Flächen hat,
- einen Deckel (80, 104-108-112), der erste und zweite entgegengesetzte Flächen hat, wobei die erste Fläche des Deckels an der ersten Fläche des Substrats befestigt ist,
- wenigstens einen Hohlraum (86), der zwischen dem Deckel und dem Substrat definiert ist,
- wenigstens ein Nanoobjekt (72) in dem Hohlraum, und
- erste dotierte Zonen (88-90, 118, 124, 130, 136), die in dem Substrat im Bereich seiner ersten Fläche sind, wobei das Nanoobjekt elektrisch mit wenigstens zwei der ersten dotierten Zonen verbunden ist,

**dadurch gekennzeichnet, dass** sie ferner umfasst:

- zweite dotierte Zonen (92-94, 126, 132, 138), die in dem Deckel im Bereich seiner ersten Fläche sind, und die elektrisch mit den ersten dotierten Zonen verbunden sind, und
- Mittel zur Kontaktherstellung (96-98, 113-114-115-116, 128, 134, 140), die von der zweiten Fläche zur ersten Fläche des Deckels verlaufen und in den zweiten dotierten Zonen münden, wobei diese Mittel elektrisch mit den zweiten Zonen verbunden sind.

**2.** Struktur zur Einkapselung nach Anspruch 1, bei der die zweiten dotierten Zonen (92-94, 126, 132, 138) wenigstens teilweise in direktem Kontakt mit den ersten dotierten Zonen sind.

**3.** Struktur zur Einkapselung nach Anspruch 1 oder 2, bei der das Substrat (74) eine erste Vielfachschicht (102, 106, 110) ist und wenigstens eine erste Widerstandsschicht (102) im Bereich der ersten Fläche des Substrats umfasst, und bei der die ersten dotierten Zonen (88, 90) in der ersten Widerstandsschicht wenigstens über einen Teil der Dicke der ersten Widerstandsschicht gebildet sind.

**4.** Struktur zur Einkapselung nach Anspruch 3, bei der das Substrat (74) vom Typ Halbleiter auf Isolator ist und somit eine erste halbleitende Oberflächenschicht (102) umfasst, und bei der die erste Widerstandsschicht durch die erste halbleitende Oberflächenschicht gebildet ist.

**5.** Struktur zur Einkapselung nach einem der Ansprüche 1 bis 4, bei der der Deckel (80) eine zweite Vielfachschicht (104, 108, 112) ist und wenigstens eine zweite Widerstandsschicht (104) im Bereich der ersten Fläche des Deckels umfasst, und bei der die zweiten dotierten Zonen (92, 94) in der zweiten Widerstandsschicht wenigstens über einen Teil der Dicke der zweiten Widerstandsschicht gebildet sind.

**6.** Struktur zur Einkapselung nach Anspruch 5, bei der der Deckel (80) vom Typ Halbleiter auf Isolator ist und somit eine zweite halbleitende Oberflächenschicht (104) umfasst, und bei der die zweite Widerstandsschicht durch die zweite halbleitende Oberflächenschicht gebildet ist.

**7.** Struktur zur Einkapselung nach einem der Ansprüche 1 bis 6, bei der die Mittel zur Kontaktherstellung Durchführungen (96-98, 128, 134, 140) umfassen, die den Deckel durchsetzen.

**8.** Struktur zur Einkapselung nach einem der Ansprüche 1 bis 6, bei der die Mittel zur Kontaktherstellung umfassen:

- Löcher (113, 114), die sich von den zweiten dotierten Zonen (92, 94) zur zweiten Fläche des Deckels (80) aufweitend verlaufen, und
- elektrisch leitende Drähte (115, 116), die jeweils in den Löchern angeordnet sind, und die jeweils elektrisch mit den zweiten dotierten Zonen (92, 94) verbunden sind.

**9.** Struktur zur Einkapselung nach einem der Ansprüche 1 bis 6, bei der die Mittel zur Kontaktherstellung umfassen:

- Löcher (113, 114), die sich von den zweiten dotierten Zonen (92, 94) zur zweiten Fläche des Deckels (80) aufweitend verlaufen, und
- elektrisch leitende Teststifte, die jeweils in den Löchern angeordnet und dazu ausgelegt sind, jeweils elektrisch mit den zweiten dotierten Zonen (92, 94) verbunden zu sein.

**10.** Struktur zur Einkapselung nach einem der Ansprüche 1 bis 9, bei der die erste Fläche des Deckels (80) an der ersten Fläche des Substrats (74) durch Kleben befestigt ist.

**11.** Struktur zur Einkapselung nach Anspruch 10, bei der die Verklebung direkt ist.

**12.** Verfahren zur Herstellung der Struktur zur Einkapselung nach einem der Ansprüche 1 bis 11, bei dem:

- man die ersten dotierten Zonen (88, 90) in dem Substrat (74) bildet,
- man den Hohlraum (86) in dem Deckel (80) bildet,
- man die Mittel zur Kontaktherstellung (96, 98) in dem Deckel bildet,
- man die zweiten dotierten Zonen (92, 94) in dem Deckel (80) bildet,
- man das wenigstens eine Nanoobjekt (7) mit den wenigstens zwei ersten dotierten Zonen (88, 90) verbindet, und
- man den Deckel (80) mit dem Substrat (74) zusammenfügt und verklebt.

**13.** Verfahren zur Herstellung der Struktur zur Einkapselung nach Anspruch 12, bei dem man nach dem Schritt der Realisierung der ersten dotierten Zonen und/oder der zweiten dotierten Zonen einen Schritt der jeweiligen Glättung der ersten Fläche des Substrats (74) und/oder der ersten Fläche des Deckels (80) durchführt.

**14.** Verfahren zur Herstellung der Struktur zur Einkapselung nach einem der Ansprüche 12 oder 13, bei dem die Verklebung eine direkte Verklebung ist.

**Claims**

**1.** Structure for encapsulation of at least one nano-object comprising:

- a substrate (74, 102-106-110) with opposite first and second faces,
- a cap (80, 104-108-112) with opposite first and second faces, the first face of the cap being fixed to the first face of the substrate,
- at least one cavity (86) defined between the cap and the substrate,
- at least one nano-object (72) in the cavity, and
- first doped zones (88-90, 118, 124, 130, 136) that are in the substrate on the first face of the substrate, the nano-object being electrically connected to at least two of said first doped zones,

**characterised in that** it also comprises:

- second doped zones (92-94, 126, 132, 138) that are in the cap on the first face of the cap and that are electrically connected to the first doped zones, and
- means of making contact (96-98, 113-114-115-116, 128, 134, 140) that range from the second face to the first face of the cap and that open up on the second doped zones, these means being electrically connected to these said second zones.

**2.** Encapsulation structure according to claim 1, in which the second doped zones (92-94, 126, 132, 138) are at least partially in direct contact with the first doped zones.

**3.** Encapsulation structure according to claim 1 or 2, in which the substrate (74) is a first multi-layer (102, 106, 110) and comprises at least a first resistive layer (102) on the first face of the substrate, and in which the first doped zones (88, 90) are formed in the first resistive layer, on at least part of the thickness of the first resistive layer.

**4.** Encapsulation structure according to claim 3, in which the substrate (74) is of the semiconductor on insulator type and it thus comprises a first semiconducting surface layer (102), and in which the first resistive layer is formed by the first semiconducting surface layer.

**5.** Encapsulation structure according to any one of claims 1 to 4, in which the cap (80) is a second multi-layer (104, 108, 112) and it comprises at least one second resistive layer (104) on the first face of the cap, and in which the second doped zones (92, 94) are formed in the second resistive layer, on at least part of the thickness of the second resistive layer.

**6.** Encapsulation structure according to claim 5, in which the cap (80) is of the semiconductor on insulator type and it thus comprises a second semiconducting surface layer (104), and in which the second resistive layer is formed by the second semiconducting surface layer.

**7.** Encapsulation structure according to any one of claims 1 to 6, in which the means of making contact include vias (96-98, 128, 134, 140) passing through the cap.

**8.** Encapsulation structure according to any one of claims 1 to 6, in which the contact means include:

- holes (113, 114) that taper outwards from the second doped zones (92, 94) to the second face of the cap (80), and
- electrically conducting wires (115, 116) respectively arranged in said holes and that are electrically connected to the corresponding second doped zones (92, 94) respectively.

**9.** Encapsulation structure according to any one of claims 1 to 6, in which the contact means include:

- holes (113, 114) that taper outwards from the second doped zones (92, 94) to the second face of the cap (80), and
- electrically conducting test points, respectively arranged in said holes and adapted to be electrically connected to the corresponding second doped zones (92, 94) respectively.

10. Encapsulation structure according to any one of claims 1 to 9, in which the first face of the cap (80) is fixed to the first face of the substrate (74) by bonding.

11. Encapsulation structure according to claim 10, in which bonding is direct.

12. Method of fabricating the encapsulation structure according to any one of claims 1 to 11, in which:

- the first doped zones (88, 90) are formed in the substrate (74),
- the cavity (86) is formed in the cap (80),
- the means of making contact (96, 98) are formed in the cap,
- the second doped zones (92, 94) are formed in the cap (80),
- said at least one nano-object (7) is connected to said at least two first doped zones (88, 90), and
- the cap is assembled and bonded (80) to the substrate (74).

13. Method of fabricating the encapsulation structure according to claim 12 in which a smoothing step of said first face of the substrate (74) and/or said first face of the cap (80) is / are carried out after the step to make the first doped zones and/or the second doped zones respectively.

14. Method of fabricating the encapsulation structure according to either claim 12 or 13, in which bonding is a direct bonding.

FIG. 1

FIG. 2

FIG. 3

FIG. 4

FIG. 5A

FIG. 5B

FIG. 6

FIG. 7

FIG. 8

FIG. 9A

FIG. 9B

FIG. 9C

EP 3 007 218 B1

FIG. 9D

FIG. 10

21

FIG. 11

FIG. 12

FIG. 13

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **O. ENGSTRÖM ; S. BENGSTSSON ; G.I. ANDERSSON ; A. JAUHIAINEN ; J. ELECTRO-CHEM.** *Soc.,* 12 Décembre 1992, vol. 139

- **S. ESSIG ; F. DIMROTH.** *ECS Journal of Solid State Science and Technology,* 2013, vol. 2 (9), Q178-Q181